# EUROPEAN PATENT APPLICATION

(11) **EP 4 198 432 A1**
(43) Date of publication of application: **21.06.2023**
(21) Application number: 21215729.1
(22) Date of filing: 17.12.2021
(51) Int. Cl.: F28D 7/00, F28F 1/36, H02K 5/20, H02K 9/19

(54) **A HEAT EXCHANGER OF AN ELECTRIC MODULE**

(71) Applicant: Valeo eAutomotive Germany GmbH, 91056 Erlangen (DE)
(72) Inventor: RAYYA, Monzer, 91056 Erlangen (DE)
(74) Representative: Valeo Powertrain Systems

(57) **Abstract**

The invention concerns a heat exchanger (50) configured to dissipate heat generated by an electric module of an automobile vehicle, the heat exchanger (50) comprising: a tubular body (51) defining a hollow portion to accommodate an electric device of the electric module; an outer channel (10) being formed in the tubular body (51) and being configured to allow a first cooling medium to flow through according to a first flow direction (31); an inner channel (20) being formed in the tubular body (51) and being configured to allow a second cooling medium to flow through according to a second flow direction (32); wherein the outer channel (10) is superimposed on the inner channel (20) which is located between the electric device and the outer channel (10).

## Description

### FIELD OF THE INVENTION

The present invention concerns equipment for an automotive vehicle, such as an electric vehicle (EV) or a hybrid vehicle (HV).

The present invention relates, in particular, to a heat exchanger configured to efficiently dissipate heat generated by an electric module of an automotive vehicle.

### BACKGROUND OF THE INVENTION

An electric module of an electric vehicle or a hybrid vehicle, such as an electric drive, comprises devices such as a motor, a gearbox and an inverter, etc. During operation of the electric module, the devices and components generate heat and must be cooled to be operational. Efficient cooling of the electric module makes it possible to increase the service life of the electric module. Therefore, the electric module comprises a cooling system for dissipating the heat generated by the devices and components of the electric module.

The cooling system comprises, a first cooling circuit configured to dissipate the heat generated by the motor and the gearbox, and a second cooling circuit configured to dissipate the heat generated by the inverter. In general, the first cooling circuit is an oil cooling circuit and the second cooling circuit is a water cooling circuit or a water/glycol cooling system.

The cooling system comprises further a heat exchanger located between the first and the second cooling circuits. However, the efficiency of heat dissipation achieved by existing heater exchangers are not efficient enough.

There is therefore a need to improve the structure of the heat exchanger in order to obtain a better heat exchange efficiency so as to improve the heat dissipation of the electric module of the vehicle.

### SUMMARY OF THE INVENTION

The present invention concerns a heat exchanger configured to dissipate heat generated by an electric module of an automobile vehicle, the heat exchanger comprising: a tubular body defining a hollow portion to accommodate an electric device of the electric module; an outer channel being formed in the tubular body and being configured to allow a first cooling medium to flow through according to a first flow direction ; an inner channel being formed in the tubular body and being configured to allow a second cooling medium to flow through according to a second flow direction ; wherein the outer channel is superimposed on the inner channel which is located between the electric device and the outer channel.

Therefore, the heat exchanger according to the present invention allows a better heat exchange efficiency so as to improve the heat dissipation of the electric module of the vehicle.

The electric device is for example an electric motor. The heat exchanger could be integrated in a housing of the electric device, or alternatively, be a separate device distinct from the electric device.

According to an embodiment, the outer and the inner channels are respectively a serpentine channel comprising main sections and turnaround sections, wherein the main sections and the turnaround sections of the serpentine channel are alternatively arranged, the main sections of the serpentine channel being parallel to each other, the turnaround sections being respectively connected to two of the main sections of the serpentine channel.

According to an embodiment, the outer and the inner channels are respectively a flat serpentine channel.

Advantageously, the outer and the inner channels are respectively a flat serpentine channel presenting an elongated rectangular cross-section.

Preferably, the heat exchanger comprises a longitudinal length which is parallel to a central axis of the heat exchanger, the longitudinal length of the heat exchanger being defined by a distance measured along with the central axis and between a first and a second ends of the heat exchanger.

Advantageously, the longitudinal length of the heat exchanger can either be greater than, or be shorter than, the longitudinal length of the electric device (e.g. the longitudinal length of the motor), depending on the amount of the heat losses which need to be dissipated.

According to an embodiment, the outer channel is superimposed on the inner channel and is parallel to the inner channel. In addition, with respect to the central axis of the heat exchanger, the outer channel and the inner channel are radially aligned.

According to an embodiment, the main sections of the outer channel and those of the inner channel are respectively parallel to the longitudinal length of the heat exchanger. Moreover, the turnaround sections of the outer and the inner channels are located at the first end and the second end of the heat exchanger.

Preferably, the main sections of the outer channel and those of the inner channel are respectively not parallel to the longitudinal length of the heat exchanger. In addition, a first angle formed by each of the main sections and one of the two edges of the tube body, is equal to a second angle formed by each of the main sections and the edge of the tube body.

According to an embodiment, the first angle and the second angle are respectively comprised of between 15 and 90 degrees. Advantageously, the first and second angles are respectively comprised of between 20 and 45 degrees.

Advantageously, the second flow direction can be opposite to the first flow direction, or alternatively, can be same with the first flow direction.

According to another embodiment, the outer channel is superimposed on the inner channel and is not parallel to the inner channel, and the main sections of the outer channel and those of the inner channel are respectively not parallel to the longitudinal length of the heat exchanger. In addition, with respect to the central axis of the heat exchanger, the outer channel and the inner channel are not radially aligned. Moreover, the first flow direction and the second flow direction form several intersections.

Preferably, the tubular body comprises an outer tubular layer comprising the outer channel, and an inner tubular layer comprising the inner channel; the outer channel approximately filling the thickness of the outer tubular layer; the inner channel approximately filling the thickness of the inner tubular layer.

According to an embodiment, the outer and the inner channels are respectively a flat serpentine tube, and are bended as well as are mounted, respectively in the outer tubular layer and in the inner tubular layer of the tubular body.

According to another embodiment, the outer and the inner channels are respectively defined by compartment ribs of the outer tubular layer and by compartment ribs of the inner tubular layer. One of the compartment ribs of the outer tubular layer is located between every two of the adjacent main sections of the outer channel, such that the first cooling medium flows opposite directions in said two adjacent main sections. Furthermore, one of the compartment ribs of the inner tubular layer is located between every two of the adjacent main sections of the inner channel, such that the second cooling medium flows opposite directions in the two adjacent main sections.

Preferably, the outer and the inner channels comprise respectively an inlet and an outlet that are radial inlets and outlets via which the first and second media are respectively conducted in and discharged from the inner and the outer channels; or alternatively, are axial inlets and outlets via which the first and second media are respectively conducted in and discharged from the inner and the outer channels according to a direction parallel to the central axis.

Advantageously, the outer and the inner channels fill the thickness of the tubular body.

Furthermore, the present invention concerns an electric module comprising an electric motor and a heat exchanger as described above, wherein the electric motor is accommodated in a hollow portion defined by the tubular body of the heat exchanger.

These and other objects, features, aspects and advantages of the present invention will become apparent to those skilled in the art from the following detailed description, which, taken in conjunction with the annexed drawings, discloses preferred embodiments of the present invention.

### BRIEF DESCRIPTION OF THE DRAWINGS

The invention will be better understood on reading the description that follows, and by referring to the appended drawings given as non-limiting examples, in which identical references are given to similar objects and in which:
- Figure 1 illustrates a heat exchanger according to an embodiment of the invention;
- Figure 2 illustrates that an outer channel and an inner channel of the heat exchanger respectively comprises a radial inlet and a radial outlet, according to an embodiment of the invention;
- Figure 3 illustrates that the outer channel and the inner channel of the heat exchanger respectively comprises an axial inlet and an axial outlet, according to an embodiment of the invention;
- Figure 4 illustrates that the heat exchanger according to a first embodiment of the invention;
- Figures 5 and 6 illustrate respectively the outer channel and the inner channel of the heat exchanger according to the first embodiment of the invention;
- Figures 7 and 8 illustrate respectively the outer channel and the inner channel of the heat exchanger according to a second embodiment of the invention;
- Figure 9 illustrates a first and a second flow directions according to the second embodiment of the invention;
- Figure 10 illustrates a first end of the heat exchanger (which is also a cross-sectional view of the heat exchanger) according to the second embodiment of the invention;
- Figure 11 illustrates the first end of the heat exchanger (which is also a cross-sectional view of the heat exchanger) according to a third embodiment of the invention; and
- Figures 12 and 13 respectively illustrate that the first flow direction is identical to, or opposite to, the second flow direction, according to the third embodiment of the invention.

### DETAILED DESCRIPTION

Several embodiments of the present invention will be detailed hereafter with reference to the drawings. It will be apparent to those skilled in the art from this present disclosure that the following description of these embodiments of the present invention are provided for illustration only and not for the purpose of limiting the invention as defined by the appended claims and their equivalents.

An electric module of an automobile vehicle (e.g. an electric vehicle or a hybrid vehicle) comprises electric devices (e.g. an electric motor, an inverter, etc.) which generate heat during operation, and a cooling system configured to dissipate the generated heat. The cooling system comprises a first cooling circuit of a motor and of a gearbox, a second cooling circuit of an inverter, and a heat exchanger 50. The first and the second cooling circuits are, for example, respectively an oil cooling circuit and a water cooling circuit.

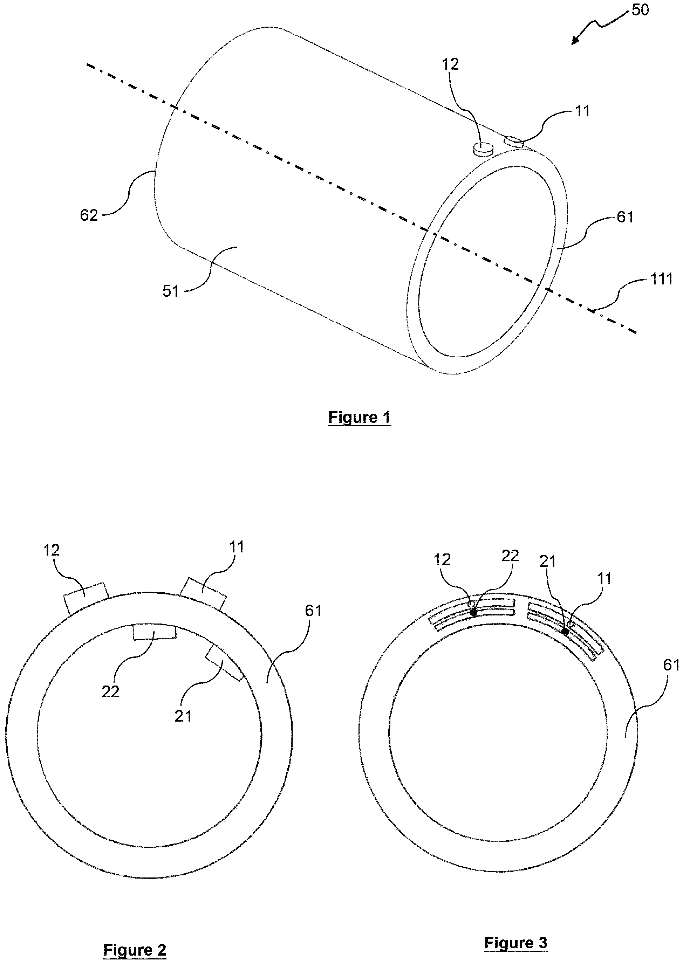

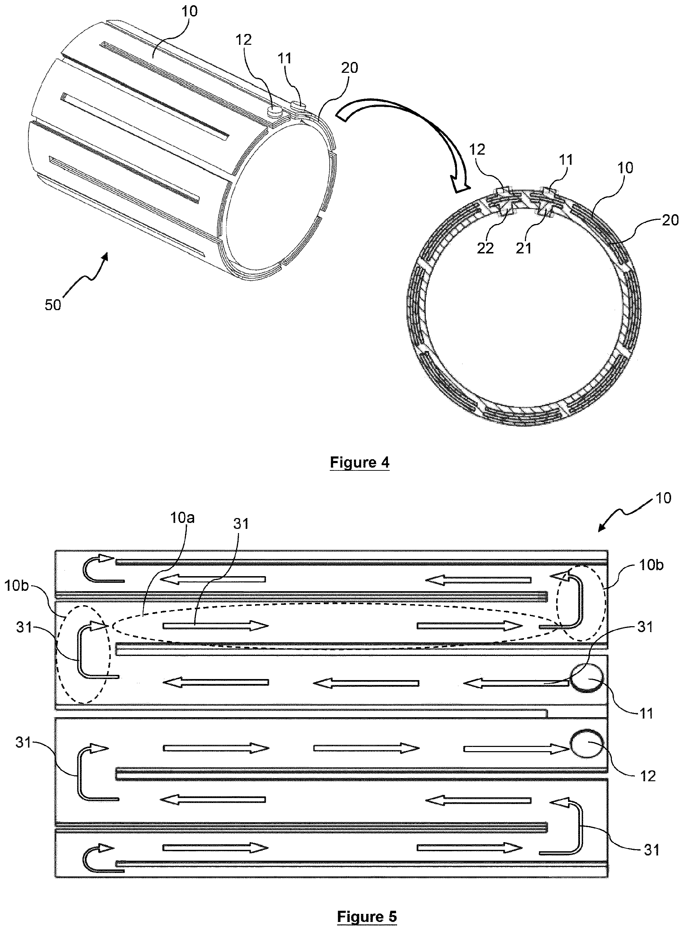

Figure 1 illustrates the heat exchanger 50 according to an embodiment of the invention. An electric device, such as an electric motor (not illustrated in figures) of the electric module, is arranged to be accommodated and be surrounded by the heat exchanger 50. The heat exchanger 20 could be integrated in a housing of the electric device, or alternatively, be a separate device distinct from the electric device. The motor rotates about a rotation axis which is identical to a central axis 111 of the heat exchanger 50. The heat exchanger 50 is configured to dissipate the generated heat. A first, a second and a third embodiments of the heat exchanger 50 are respectively depicted in Figures 4 to 6, Figures 7 to 10, and Figures 10 to 13.

The heat exchanger 50 is in a tube shape and comprises a tubular body 51 which defines a hollow portion to accommodate the electric device. The tubular body 51 comprises a first end 61 and a second end 62. A longitudinal length of the heat exchanger 50, being parallel to the central axis 111, is defined by a distance measured along with the central axis 111 and between the first and the second ends 61, 62. The longitudinal length of the heat exchanger 50 can either be greater than, or be shorter than, the longitudinal length of the electric device (e.g. the longitudinal length of the motor), depending on the amount of the heat losses which need to be dissipated.

As illustrated in Figures 1, 4 and 7, the heat exchanger 50 further comprises an outer channel 10 and an inner channel 20 both formed in the tubular body 51. The outer channel 10 is superimposed on the inner channel 20. The inner channel 20 is located between the electric device (e.g. the motor) and the outer channel 10. Preferably, the outer and the inner channels 10, 20 approximately fill the thickness of the tubular body 51. The tubular body 51 is preferably made of a metal material such as steel, aluminum or copper. Advantageously, the tubular body 51 is made of aluminum alloy or copper alloy.

Preferably, the tubular body 51 comprises an outer tubular layer 510 where the outer channel 10 is formed, and an inner tubular layer 520 where the inner channel 20 is formed. The outer channel 10 approximately fills the thickness of the outer tubular layer 510, and the inner channel 20 approximately fills the thickness of the inner tubular layer 520.

The outer channel 10 and the inner channel 20 respectively allows a first cooling medium and a second cooling medium to flow through. The outer and the inner channels 10, 20 are adjacent to each other so as to allow that a heat exchange between the outer and the inner channels 10, 20 occurs through channel walls of the outer and the inner channels 10, 20 as well as through the first and the second cooling media.

The outer channel 10 comprises a first inlet 11 and a first outlet 12 which are respectively configured to conduct and to discharge the first cooling medium. The first cooling medium flows through the outer channel 10 according to a first flow direction 31. The first inlet 11 and the first outlet 12 can be both located at the first end 61 (as illustrated in Figures 2 and 3), or both at the second end 62. Alternatively, one of the first inlet 11 and the first outlet 12 is located at the first end 61 and the other one is located at the second end 62. The first inlet 11 and the first outlet 12 can be switched if needed.

Similarly, the inner channel 20 comprises a second inlet 21 and a second outlet 22 which are respectively configured to conduct and to discharge a second cooling medium. The inner channel 20 allows the second cooling medium to flow through according to a second flow direction 32. The second inlet 21 and the second outlet 22 can be both located at the first end 61 (as illustrated in Figures 2 and 3), or both at the second end 62. Alternatively, one of the second inlet 21 and the second outlet 12 is located at the first end 61 and the other one is located at the second end 62. The second inlet 21 and the second outlet 22 can be switched if needed.

According to an embodiment illustrated in Figure 2, the inlets 11, 21 and the outlets 12, 22 can be radial inlets and outlets via which the first and the second media are respectively conducted in and discharged from the inner and the outer channels 10, 20. According to an embodiment illustrated in Figure 3, the inlets 11, 21 and the outlets 12, 22 can be axial inlets and outlets via which the first and the second media are respectively conducted in and discharged from the inner and the outer channels 10, 20 according to a direction parallel to the central axis 111.

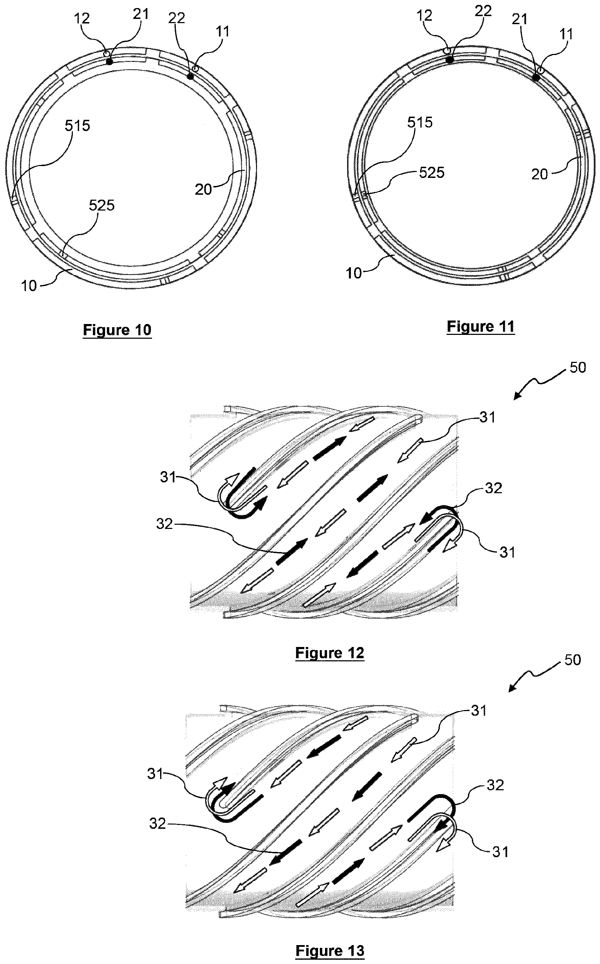

The first cooling medium is a thermal fluid and is preferably oil, water, glycol or a glycol-water mixture. The second cooling medium is also a thermal fluid, and is preferably water, a glycol-water mixture, glycol or oil. The second cooling medium can be identical or different from the first cooling medium. The second flow direction 32 can be opposite to the first flow direction 31, as depicted in the first and the third embodiments illustrated in Figures 3 and 12. Alternatively, the second flow direction 32 is same with the first flow direction 31, as illustrated in Figure 13.

The outer and the inner channels 10, 20 are respectively a serpentine channel comprising main sections (10a, 20a) and turnaround sections (10b, 20b), as described in Figures 5 to 8. The main sections 10a and the turnaround sections 10b of the outer channel 10 are alternatively arranged, wherein the main sections 10a are parallel to each other, and the turnaround sections 10b are respectively connected to two of the main sections 10a. Similarly, the main sections 20a and the turnaround sections 20b of the inner channel 20 are alternatively arranged, wherein the main sections 20a are parallel to each other, and the turnaround sections 20b are respectively connected to two of the main sections 20a. Advantageously, the outer and the inner channels 10, 20 are respectively a flat serpentine channel presenting an elongated rectangular cross-section (as illustrated in Figures 5 to 8).

According to an embodiment, the outer and the inner channels 10, 20 are respectively a flat serpentine tube, and are bended as well as are mounted, respectively in the outer tubular layer 510 and in the inner flat serpentine tube 20. The outer and the inner flat serpentine tubes 10, 20 are preferably made of a material of high thermal conductivity, such as copper or aluminum.

Alternatively, the outer and the inner channels 10, 20 are formed integrally with the outer and the inner tubular layer 510, 520 of the tubular body 51. In this way, the outer and the inner channels 10, 20 are embedded, without being mounted, into the outer and the inner tubular layers 510, 520 of the heat exchanger 50.

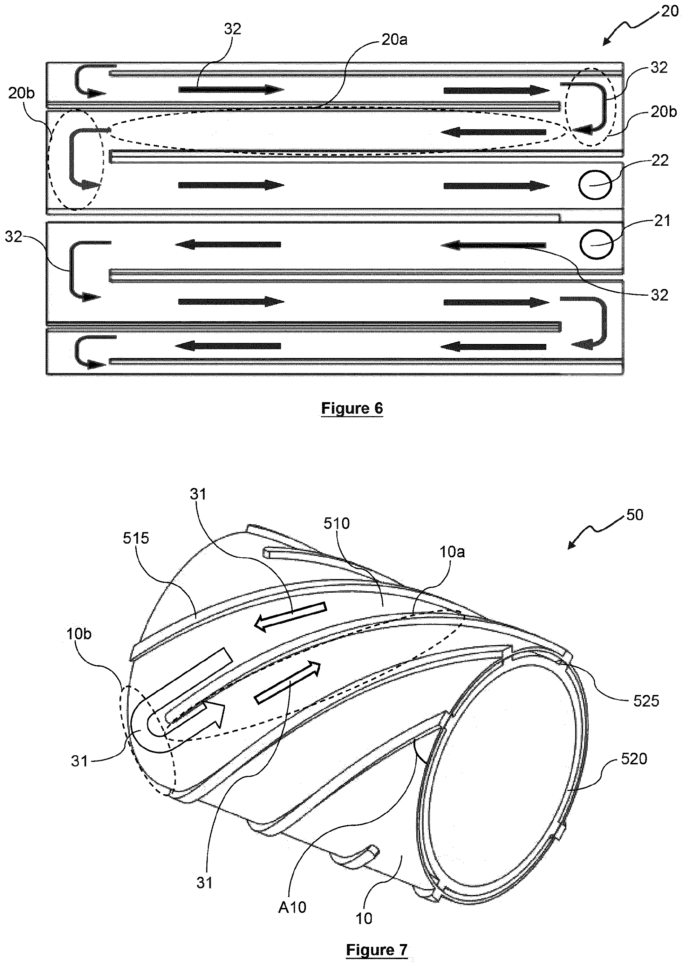

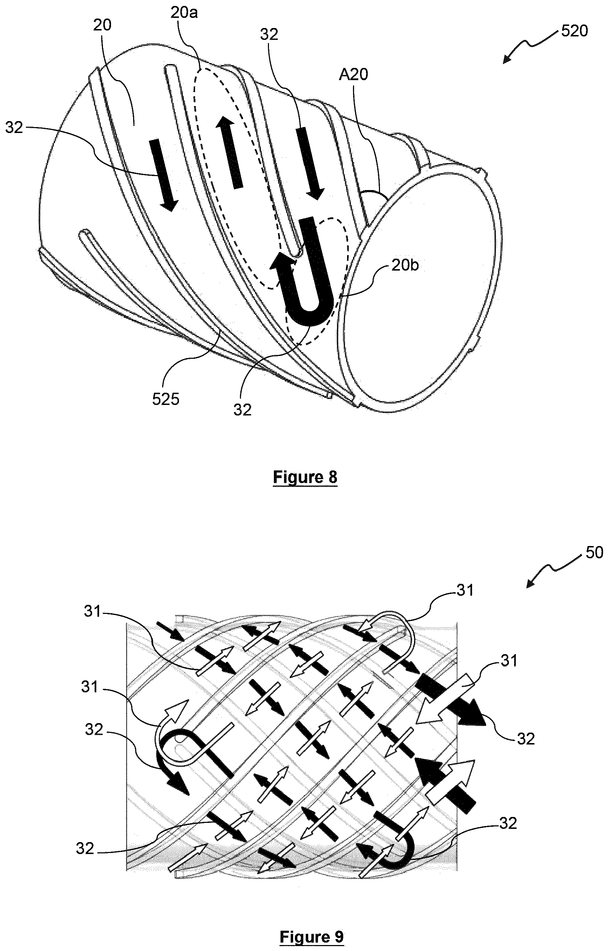

According to another embodiment, each of the outer and the inner tubular layers 510, 520 comprises compartment ribs (515, 525) respectively configured to define the outer channel 10 and the inner channel 20. As illustrated in Figures 7 and 8, one of the compartment ribs 515 of the outer tubular layer 510 is located between every two of the adjacent main sections 10a of the outer channel 10, such that the first cooling medium flows opposite directions in said two adjacent main sections 10a. Similarly, one of the compartment ribs 525 of the inner tubular layer 520 is located between every two of the adjacent main sections 20a of the inner channel 20, such that the second cooling medium flows opposite directions in said two adjacent main sections 20a.

As mentioned above, Figures 4 to 6 illustrate the heat exchanger 50 according to the first embodiment of the invention. Figures 5 and 6 illustrate respectively the outer channel 10 and the inner channel 20 of the heat exchanger 50 according to the first embodiment.

According to said first embodiment, the main sections 10a of the inner channel 10 and those (20a) of the inner channel 20 are respectively parallel to the longitudinal length of the heat exchanger 50. The turnaround sections (10b, 20b) of the inner and the inner channels 10, 20 are located at the first end 61 and the second end 62 of the heat exchanger 50. The outer channel 10 is superimposed on the inner channel 20 and is parallel to the inner channel 20. More precisely, with respect to the central axis 111 of the heat exchanger 50, the outer channel 10 and the inner channel 20 are radially aligned. The second flow direction 32 can be opposite to the first flow direction 31, or alternatively, can be same with the first flow direction 31.

Figures 7 to 10 illustrate the heat exchanger 50 according to the second embodiment of the invention. Figures 7 and 8 illustrate respectively the outer channel 10 and the inner channel 20 of the heat exchanger 50 according to the second embodiment. Figure 9 illustrates the first and the second flow directions 31 and 32 according to the second embodiment. Figure 10 illustrates the first end 61 (which is also a cross-sectional view of the heat exchanger 50) according to the second embodiment.

Figures 11 to 13 illustrate the heat exchanger 50 according to the third embodiment of the invention. Figure 11 illustrates the first end 61 (which is also a cross-sectional view of the heat exchanger 50) according to the third embodiment. Figures 12 and 13 respectively illustrate that the first flow direction 31 is identical to, or opposite to, the second flow direction 32, according to the third embodiment.

According to the second and the third embodiments, the main sections 10a of the outer channel 10 and those (20a) of the inner channel 20 are respectively not parallel to the longitudinal length of the heat exchanger 50. For each of the main sections 10a of the outer channel 10, a first angle A10 formed by the main section 10a and one of two edges of the tube body 51, is preferably comprised of between 15 and 90 degrees. Advantageously, the first angle A10 is comprised of between 20 and 45 degrees. Similarly, for each of the main sections 20a of the inner channel 20, a second angle A20 formed by the main section 20a and the edge of the tube body 51, is preferably comprised of between 15 and 90 degrees. Advantageously, the second angle A20 is comprised of between 20 and 45 degrees.

A difference between the second and the third embodiments is described as below.

According to the second embodiment, the outer channel 10 is superimposed on the inner channel 20, wherein the first flow direction 31 and the second flow direction 32 form several intersections, as described in Figure 9.

Different from the second embodiment but similar to the first embodiment, the outer channel 10 of the third embodiment is superimposed on and is parallel to the inner channel 20. More precisely, with respect to the central axis 111 of the heat exchanger 50, the outer channel 10 and the inner channel 20 are radially aligned. The main sections 10a of the outer channel 10 and those (20a) of the inner channel 20 are radially aligned. The turnaround sections 10b of the outer channel 10 and those (20b) of the inner channel 20 are also radially aligned. For example, the outer and the inner channels 10, 20 of the third embodiment can both be structurally identical to the outer channel 10 of the second embodiment, as depicted in Figure 7. Alternatively, the outer and the inner channels 10, 20 of the third embodiment can both be structurally identical to the inner channel 20 of the second embodiment, as depicted in Figure 8.

According to the third embodiment, the first angle A10 formed by each of the main sections 10a and one of the two edges of the tube body 51, is equal to the second angle A20 formed by each of the main sections 20a and the edge of the tube body 51.

Figures 10 and 11 illustrate that the outer channel 10 and the inner channel 20 can be respectively defined by the compartment ribs 515 of the outer tubular layer 510 and by the compartment ribs 525 of the inner tubular layer 520 according to the invention. Compared to Figure 11 illustrating an alignment of the outer and the inner channels 10, 20 (as well as an alignment of the compartment ribs 515 and the compartment ribs 525), Figure 10 illustrates a non-alignment of the outer and the inner channels 10, 20 (as well as a non-alignment of the compartment ribs 515 and the compartment ribs 525).

According to the third embodiment, the first flow direction 31 can be opposite to the second flow direction 32, as illustrated in Figure 12. Alternatively, the first flow direction 31 can be same with the second flow direction 32, as illustrated in Figure 13.

The heat exchanger 50 allows thus a heat exchange between the outer and the inner channels 10, 20 to occur through channel walls of the outer and the inner channels 10, 20 as well as through the first and the second cooling media.

The heat exchanger according to the present invention allows thus to dissipate, for instance, 8 kW losses from a motor and a gearbox of an electric module, and to effectively reduce the oil temperature of the motor. The heat exchange efficiency as well as the heat dissipation of the electric module are thus improved.

## Claims

1. A heat exchanger (50) configured to dissipate heat generated by an electric module of an automobile vehicle, the heat exchanger (50) being **characterized in** comprising:
- a tubular body (51) defining a hollow portion to accommodate an electric device of the electric module;
- an outer channel (10) being formed in the tubular body (51) and being configured to allow a first cooling medium to flow through according to a first flow direction (31);
- an inner channel (20) being formed in the tubular body (51) and being configured to allow a second cooling medium to flow through according to a second flow direction (32);
wherein the outer channel (10) is superimposed on the inner channel (20) which is located between the electric device and the outer channel (10).

2. The heat exchanger (50) according to the preceding claim, wherein the outer and the inner channels (10, 20) are respectively a serpentine channel comprising main sections (10a, 20a) and turnaround sections (10b, 20b), wherein the main sections and the turnaround sections of the serpentine channel are alternatively arranged, the main sections of the serpentine channel being parallel to each other, the turnaround sections being respectively connected to two of the main sections of the serpentine channel.

3. The heat exchanger (50) according to any one of the preceding claims, wherein the outer and the inner channels (10, 20) are respectively a flat serpentine channel.

4. The heat exchanger (50) according to any one of the preceding claims, wherein the heat exchanger (50) comprises a longitudinal length which is parallel to a central axis (111) of the heat exchanger (50), the longitudinal length of the heat exchanger (50) being defined by a distance measured along with the central axis (111) and between a first and a second ends (61, 62) of the heat exchanger (50).

5. The heat exchanger (50) according to claim 4, wherein:
- the outer channel (10) is superimposed on the inner channel (20) and is parallel to the inner channel (20), and
- with respect to the central axis (111) of the heat exchanger (50), the outer channel (10) and the inner channel (20) are radially aligned.

6. The heat exchanger (50) according to claim 5, wherein:
- the main sections (10a) of the outer channel (10) and those (20a) of the inner channel (20) are respectively parallel to the longitudinal length of the heat exchanger (50), and
- the turnaround sections (10b, 20b) of the outer and the inner channels (10, 20) are located at the first end (61) and the second end (62) of the heat exchanger (50).

7. The heat exchanger (50) according to claim 5, wherein:
- the main sections (10a) of the outer channel (10) and those (20a) of the inner channel (20) are respectively not parallel to the longitudinal length of the heat exchanger (50), and
- a first angle (A10) formed by each of the main sections (10a) and one of the two edges of the tube body (51), is equal to a second angle (A20) formed by each of the main sections (20a) and the edge of the tube body (51).

8. The heat exchanger (50) according to any one of claims 1 to 7, wherein the second flow direction (32) can be opposite to the first flow direction (31), or alternatively, can be same with the first flow direction (31).

9. The heat exchanger (50) according to claim 4, wherein:
- the outer channel (10) is superimposed on the inner channel (20) and is not parallel to the inner channel (20), and
- the main sections (10a) of the outer channel (10) and those (20a) of the inner channel (20) are respectively not parallel to the longitudinal length of the heat exchanger (50), and
- with respect to the central axis (111) of the heat exchanger (50), the outer channel (10) and the inner channel (20) are not radially aligned, and
- the first flow direction (31) and the second flow direction (32) form several intersections.

10. The heat exchanger (50) according to any one of claims 1 to 9, wherein the tubular body (51) comprises an outer tubular layer (510) comprising the outer channel (10), and an inner tubular layer (520) comprising the inner channel (20); the outer channel (10) approximately filling the thickness of the outer tubular layer (510); the inner channel (20) approximately filling the thickness of the inner tubular layer (520).

11. The heat exchanger (50) according to the preceding claim, wherein the outer and the inner channels (10, 20) are respectively a flat serpentine tube, and are bended as well as are mounted, respectively in the outer tubular layer (510) and in the inner tubular layer (520) of the tubular body (51).

12. The heat exchanger (50) according to claim 10, wherein:
- the outer and the inner channels (10, 20) are respectively defined by compartment ribs (515) of the outer tubular layer (510) and by compartment ribs (525) of the inner tubular layer (520), and
- one of the compartment ribs (515) of the outer tubular layer (510) is located between every two of the adjacent main sections (10a) of the outer channel (10), such that the first cooling medium flows opposite directions in said two adjacent main sections (10a), and
- one of the compartment ribs (525) of the inner tubular layer (520) is located between every two of the adjacent main sections (20a) of the inner channel (20), such that the second cooling medium flows opposite directions in the two adjacent main sections (20a).

13. The heat exchanger (50) according to any one of the preceding claims, wherein the outer and the inner channels (10, 20) comprise respectively an inlet (11, 21) and an outlet (21, 22), said inlets (11, 21) and outlets (21, 22) being:
- radial inlets and outlets via which the first and second media are respectively conducted in and discharged from the inner and the outer channels (10, 20); or
- axial inlets and outlets via which the first and second media are respectively conducted in and discharged from the inner and the outer channels (10, 20) according to a direction parallel to the central axis (111).

14. The heat exchanger (50) according to any one of the preceding claims, wherein the outer and the inner channels (10, 20) fill the thickness of the tubular body (51).

15. An electric module (100) comprising an electric motor, being **characterized in** comprising a heat exchanger (50) according to any one of the preceding claims, wherein the electric motor is accommodated in a hollow portion defined by the tubular body (51) of the heat exchanger (50).
